# EUROPEAN PATENT SPECIFICATION

(11) **EP 2 629 337 B1**
(45) Date of publication and mention of the grant of the patent: **19.10.2016**
(21) Application number: 12460005.7
(22) Date of filing: 16.02.2012
(51) Int. Cl.: H01L 31/042

(54) **Application of fluorine doped tin (IV) oxide SnO2:F for making a heating layer on a photovoltaic panel, and the photovoltaic panel**
Anwendung von fluordotierem Blech (IV)-Oxid SNO2:F zum Herstellen einer Heizungsschicht auf einer Photovoltaiktafel und Photovoltaiktafel
Application d'oxyde d'étain (IV) dopé au fluor SnO2:F pour la fabrication d'une couche de chauffage sur un panneau photovoltaïque et le panneau photovoltaïque

(43) Date of publication of application: 21.08.2013
(73) Proprietor: ML SYSTEM Spólka Akcyjna, 36-062 Zaczernie (PL)
(72) Inventor: Boratynski, Pawel, 31-623 Kraków (PL); Skupien, Krzysztof, 31-640 Krakow (PL); Stanek, Edyta, 35-317 Rzeszow (PL); Cycon, Dawid, 35-317 Rzeszow (PL)
(74) Representative: Warzybok, Tadeusz

(56) References cited:
- JP-A- 8 260 638
- JP-A- 11 131 709
- JP-A- 2002 021 265
- JP-A- 2007 311 635
- US-A1- 2010 236 608
- US-A1- 2011 056 924
- Peter Gerhardinger ET AL: "Fluorine Doped Tin Oxide Coatings - Over 50 Years and Going Strong", Key Engineering Materials, vol. 380, 1 January 2008 (2008-01-01), pages 169-178, XP055241606, Aedermannsdorf ISSN: 0252-1059, DOI: 10.4028/www.scientific.net/KEM.380.169

## Description

The subject of the invention is a photovoltaic panel with heating layer made of fluorine-doped tin (IV) oxide SnO2:F. The invention is applied in a process of conversion of the electromagnetic radiation (preferably solar energy) into electric energy.

Application of fluorine doped tin (IV) oxide SnO₂:F in defrosting of the car windows is known from the state of the art.

Besides, the photovoltaic panels with laminar structure are known. The photovoltaic cells, converting solar energy into electric energy, are their most important part. Single cell is a semiconductor with a p-n junction in its structure. The photovoltaic panels are manufactured with use of various types of semiconducting materials. According to their type the panels are classified as silicon of monocrystalline type (c-Si), silicon of polycrystalline type (m-Si) and panels made in thin-layer technologies of amorphous silicon (a-Si, a-Si:H), Copper Indium Selenide (CIS) or Copper Indium Gallium Selenide (CIGS) and cadmium telluride (CdTe). Front part of the photovoltaic panels is made from glass protecting the photovoltaic cells, while the whole structure is closed in a frame which is a constructional element enabling fastening of the panel to the supporting structure.

All known photovoltaic panels, if not installed on vertical facades, are susceptible to be covered with a layer of frost or snow during precipitation at temperatures close to or below zero degrees Celsius. This results in significant loss of performance in conditions where a part of the panel surface is obscured e.g. by snow, frost, etc., and the overall efficiency of whole photovoltaic installation decreases. This problem occurs in winter, at snowy weather and temperatures below zero degrees Celsius. Known snow removal and de-icing systems of photovoltaic panels provide heating by electric heating mats made of resistance wire mounted below the panel or systems with liquid medium (a piping system mounted under the panel). By their nature, the heating mats cannot be placed directly in a place demanding de-icing or defrosting, i.e. on the front part, but they are placed under the panel. This causes undesirable heat loss on its way from the mat towards the front part of the panel.

A photovoltaic panel with a heating layer consist in application, comprising a front glass part and a frame with at least photovoltaic cell situated inside said frame, whereas the inner surface of said front part is covered with an oxide electric current conducting layer made of fluorine-doped tin(IV) oxide Sn02:F characterised in that between surface of the conducting layer and the inner surface of the photovoltaic cell, a layer of transparent polymer film is placed and inseparably and permanently bound with both layers.

In preferred embodiment photovoltaic panel is characterised in that the layer of transparent polymer film (4) is the ethylene-vinyl acetate (EVA) film.

Still in another embodiment photovoltaic panel is characterised in that layer of transparent polymer film is the polyvinyl butyral (PVB) film.

The advantage of the invention is a short time required to reach the operating temperature, and uniform temperature distribution on the surface of the photovoltaic panel. Besides, the solution provides for lower heat loss during defrosting, de-icing and the snow removal of the photovoltaic panel.

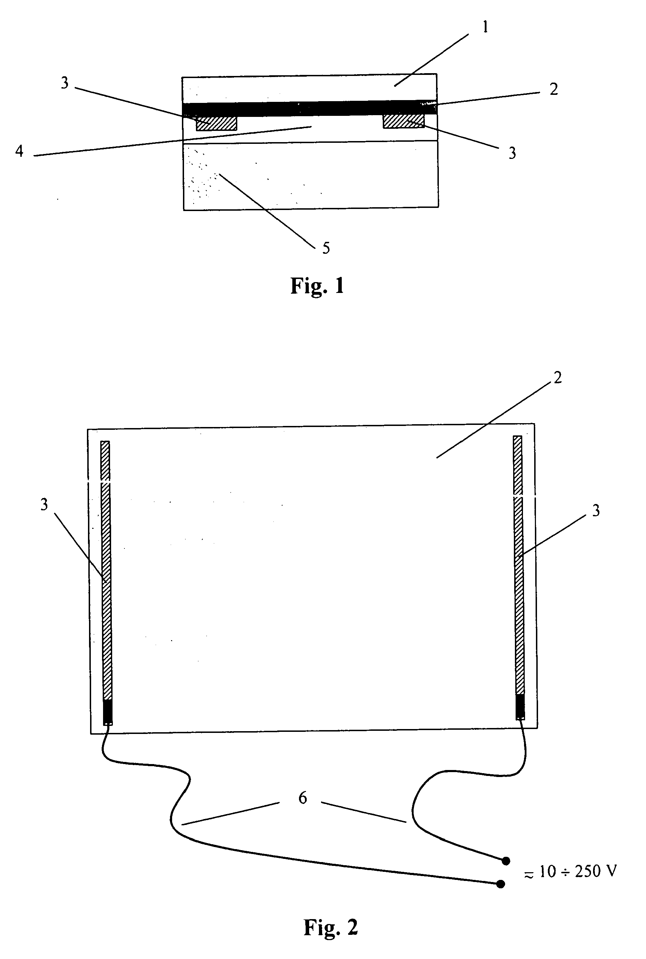

The solution according to the invention is shown on the drawing where fig. 1 shows cross-section of the photovoltaic panel, and fig. 2 shows a conductive layer of fluorine doped tin (IV) oxide SnO₂:F. and the elements of the heating circuit of the photovoltaic panel.

In shown embodiment the photovoltaic panel consists of the frame (not shown in the figure) and the front part I made of flat glass plate. On the front part I a thin film of conductive layer 2 of fluorine doped tin (IV) oxide SnO₂:F (FTO) is applied. Coated front part I is inseparably and permanently bound to the photovoltaic cell 5, for example in the process of lamination at a temperature ≤ 200°C with use of a transparent polymer film 4. This transparent polymer film 4 is for example an ethylene-vinyl acetate (EVA) film or a polyvinyl butyral (PVB) film. As a result of this operation, the conductive layer 2 of fluorine doped tin (IV) oxide SnO₂:F which is an electrical heating element, is galvanicly isolated from the photovoltaic cell 5. On the conductive layer 2 of fluorine doped tin (IV) oxide SnO₂:F, the electrodes 3 made of electrically conductive material are deposited, preferably opposite to each other. The electrodes 3 are connected to the power leads 6

Operation of the invention is as follows: power leads 6 are connected to the voltage source, DC or AC, for example of the voltage value of 10÷250V. As a result of applied voltage electric current flows through the conductive layer 2 of fluorine doped tin (IV) oxide SnO₂:F and produces heat on the resistance of this layer. Produced heat penetrates through the front part I towards a layer of frost, ice or snow, which melts exposing the photovoltaic cell 5.

## Claims

1. A photovoltaic panel with a heating layer (2) comprising a front glass part (1) and a frame with at least one photovoltaic cell (5) situated inside said frame, whereas the inner surface of said front part (1) is covered with an electric current conducting layer (2) made of fluorine-doped tin (IV) oxide SnO2:F **characterised in that** between a surface of the conducting layer (2) with electrodes (3) deposited thereon and the inner surface of the photovoltaic cell (5), a layer of transparent polymer film (4) is placed and inseparably and permanently bound with both the conductive layer (2) and the photovoltaic cell (5), such that the conductive layer (2) becomes a heating layer when the electrodes (3) are connected to a voltage source.

2. The panel according to claim 1 **characterised in that** the layer of transparent polymer film (4) is an ethylene-vinyl acetate (EVA) film.

3. The panel according to claim 1 **characterised in that** the layer of transparent polymer film (4) is a polyvinyl butyral (PVB) film.

## Patentansprüche

1. Photovoltaisches Paneel mit der Heizschicht (2), aufweisend ein gläsernes Vorderteil (1) sowie einen Rahmen mit zumindest einer photovoltaischen Zelle, die sich im Inneren des genannten Rahmens befindet, während die Innenfläche des genannten Vorderteils (1) mit einer stromleitenden Schicht (2) überzogen ist, die aus fluordotierten Zinnoxid (IV) SnO₂:F ausgeführt ist, **gekennzeichnet dadurch, dass** zwischen der Oberfläche der stromleitenden Schicht (2) mit den darauf aufgetragenen Elektroden (3) und der Innenfläche der photovoltaischen Zelle (5) eine Schicht der transparenten Polymerfolie (4) platziert und mit der leitenden Schicht (2) wie auch mit der photovoltaischen Zelle (5) fest verbunden ist, so dass die leitende Schicht zu der Heizschicht wird, wenn die Elektroden (3) an der Spannungsquelle angeschlossen werden.

2. Das Paneel nach dem Anspruch 1 **dadurch gekennzeichnet, dass** die Schicht der transparenten Polymerfolie (4) eine Folie aus dem Äthylenvinylazetat (EVA) ist.

3. Das Paneel nach dem Anspruch 1 **dadurch gekennzeichnet, dass** die Schicht der transparenten Polymerfolie (4) eine Folie aus dem Polyvinylbutyral (PVB) ist.

## Revendications

1. Le panneau photovoltaïque avec une couche chauffante (2) comprenant une partie antérieure (1) en verre et un châssis comprenant au moins une cellule photovoltaïque située à l'intérieur de dedit chassis où cette surface intérieure de ladite partie antérieure (1) est couverte d'une couche électriquement conductrice (2) faite en dopé au fluor oxyde d'étain (IV) SnO₂:F **caractérisé en ce qu**'entre la surface de cette couche conductrice (2) avec les électrodes (3) y déposées et la surface intérieure d'une cellule photovoltaïque (5) est placée et fixée en permanence, à la fois avec cette couche (2) et cette cellule photovoltaïque (5), une couche en film polymère transparent (4), de sorte que cette couche conductrice (2) devienne une couche chauffante si ces électrodes (3) sont connectées à une source de tension.

2. Le panneau selon la revendication 1 **caractérisé en ce que** cette couche en film polymère transparent (4) est un film en éthylène vinyl acétate (EVA).

3. Le panneau selon la revendication 1 **caractérisé en ce que** cette couche en film polymère transparent (4) est un film en poly(butyral de vinyle) (PVB).
